## Europäisches Patentamt
## European Patent Office
## Office européen des brevets

(11) Numéro de publication: **0 020 208**
**B1**

(12) **FASCICULE DE BREVET EUROPEEN**

(45) Date de publication du fascicule du brevet: **23.06.82**

(51) Int. Cl.³: **G 01 R 33/02, G 01 V 3/08**

(21) Numéro de dépôt: **80400623.7**

(22) Date de dépôt: **08.05.80**

(54) **Capteur magnétique utilisant l'effet magnétostrictif et dispositif de détection de proximité comportant un tel capteur.**

(30) Priorité: **16.05.79 FR 7912459**

(43) Date de publication de la demande:
**10.12.80 Bulletin 80/25**

(45) Mention de la délivrance du brevet:
**23.06.82 Bulletin 82/25**

(84) Etats contractants désignés:
**DE GB IT NL SE**

(56) Documents cités:
**FR - A - 2 365 105**
**GB - A - 508 046**

**REVUE DE PHYSIQUE APPLIQUEE, tome 5, février 1970, no. 1 B. WAKSMANN: "Possibilitiés d'application des couches minces magnétiques à la détection des champs magnétiques faibles" pages 145—149**

(73) Titulaire: **THOMSON-CSF**
**173, Boulevard Haussmann**
**F-75360 Paris Cedex 08 (FR)**

(72) Inventeur: **Castera, Jean-Paul**
**"THOMSON-CSF" SCPI 173, Bld Haussmann**
**F-75360 Paris Cedex 08 (FR)**
Inventeur: **Dupont, Jean-Marie**
**"THOMSON-CSF" SCPI 173, Bld Haussmann**
**F-75360 Paris Cedex 08 (FR)**

(74) Mandataire: **Wang, Pierre et al,**
**THOMSON-CSF SCPI 173, Bld Haussmann**
**F-75360 Paris Cedex 08 (FR)**

Courier Press, Leamington Spa, England.

# Capteur magnétique utilisant l'effet magnétostrictif et dispositif de détection de proximité comportant un tel capteur

L'invention se rapporte aux capteurs magnétiques utilisant l'effet magnétostrictif pour créer un axe d'aimantation facile permanent dans un matériau, cette aimantation étant susceptible de basculer sous l'effet d'un champ magnétique extérieur à détecter.

Un capteur magnétique du type succintement décrit ci-dessus a été décrit précédemment. Ce capteur comporte un fil formé d'un alliage Nickel-Fer particulier (permalloy). Ce fil est soumis à un traitement complexe qui lui confère des propriétés particulières quant à son aimantation. Ce traitement consiste à étirer le fil, puis à le torsader un certain nombre de fois en fixant une extrémité et en tournant l'autre extrémité d'abord dans un sens, puis dans l'autre sens. A la fin de ce traitement on constate que, lorsque le fil est placé à l'intérieur d'une bobine et qu'un champ magnétique agit sur le fil, une impulsion peut être détectée aux bornes de la bobine. Cette impulsion semble dûe au basculement de l'aimantation créée à l'intérieur du fil par effet magnétostrictif inverse à la suite des contraintes appliquées au fil. En effet, à la suite du traitement appliqué au fil, un champ coercitif fort $H_c$ est crée dans la zone où le fil a été très contraint, c'est à dire à la périphérie du fil, le champ coercitif $h_c$ au coeur du fil étant nettement moindre, lorsqu'un champ magnétique de polarisation est appliqué au fil, une aimantation est créée qui subsiste après suppression du champ de polarisation. Il y a alors création d'un champ démagnétisant qui, si il est supérieur au champ coercitif au coeur du matériau mais inférieur au champ coercitif à la périphérie du matériau, conduit à une aimantation résultante de sens différent à l'intérieur et à la périphérie du fil. Lorsqu'un tel fil est placé dans une bobine et soumis à un champ magnétique extérieur supérieur au champ démagnétisant, l'aimantation du coeur bascule. Lorsque de champ extérieur disparait, l'aimantation rebascule dans l'autre sens.

Dans un tel capteur, seule une partie du matériau contribue à la variation de flux magnétique lors du basculement de l'aimantation du fait que la périphérie du matériau a déjà son aimantation dans le même sens que celui du basculement.

De plus, l'amplitude des impulsions détectées est assez faible, de l'ordre du volt lorsque l'impédance d'entrée du système de détection est 10 kΩ. Par ailleurs, cette amplitude est assez variable d'un basculement au suivant, cette amplitude étant fonction de la quantité d'aimantation soumise au basculement, elle-même, fonction entre autres du nombre de domaines ayant rebasculé automatiquement à la fin de la phase précédente. Enfin, le temps de montée des impulsions est assez grand de l'ordre de 100 $\mu$s. Lorsqu'un tel capteur est utilisé comme capteur de position, par exemple dans le but de mesurer la vitesse de rotation d'un moteur, il est nécessaire que les pales du moteur ne passent pas à des instants trop rapprochés près du capteur; c'est à dire qu'un tel dispositif, compte-tenu du temps de montée des impulsions obtenues, ne permet pas de mesurer des vitesses rapides. De plus, l'amplitude des impulsions détectées étant assez faible, il est absolument indispensable de les amplifier avant de les utiliser par exemple, dans un circuit de comptage, ce qui impose un traitement supplémentaire.

L'invention a pour objet un capteur magnétique utilisant les effets magnétostrictifs inverses, permettant d'obtenir, à la suite d'une application momentanée d'un champ magnétique, un signal d'amplitude élevée à faible temps de montée, cette amplitude et ce temps de montée étant à peu près indépendants des conditions de fonctionnement, en particulier de la vitesse d'application du champ magnétique d'excitation et de la température.

Le capteur magnétique suivant l'invention est caractérisé en ce qu'il comporte un fil magnétique introduit dans une gaine rigide de matériau non magnétique, les formes respectives du fil et de la gaine étant telles que le fil dans sa gaine est maintenu en flexion créant ainsi des contraintes longitudinales de façon à créer dans une zone du fil une direction facile d'aimantation suivant l'axe longitudinal du fil, l'ensemble fil magnétique et gaine étant placé selon l'axe d'une bobine de détection destinée à fournir des impulsions lors de l'application momentanée d'un champ magnétique au capteur lorsque ce champ induit un basculement de l'aimantation dans le fil magnétique d'un sens à l'autre, suivant la direction facile d'aimantation.

L'invention sera mieux comprise et d'autres caractéristiques apparaitront à l'aide de la description qui suit en référence aux figures annexées.

La figure 1 représente un premier mode de réalisation du capteur magnétique suivant l'invention.

La figure 2 représente le signal détecté aux bornes de la bobine d'un tel capteur.

Les figures 3a) et 3b) représentent des schémas plus détaillés du fil magnétique utilisé dans le capteur magnétique suivant l'invention.

La figure 4 représente un second mode de réalisation du capteur magnétique selon l'invention.

La figure 5 représente le signal détecté aux bornes du capteur représente sur la figure 4.

La figure 6 représente un troisième mode de réalisation du capteur magnétique suivant l'invention.

La figure 7 représente le signal détecté aux bornes du capteur représenté sur la figure 6.

La figure 8 représente un autre mode de réalisation du capteur suivant l'invention.

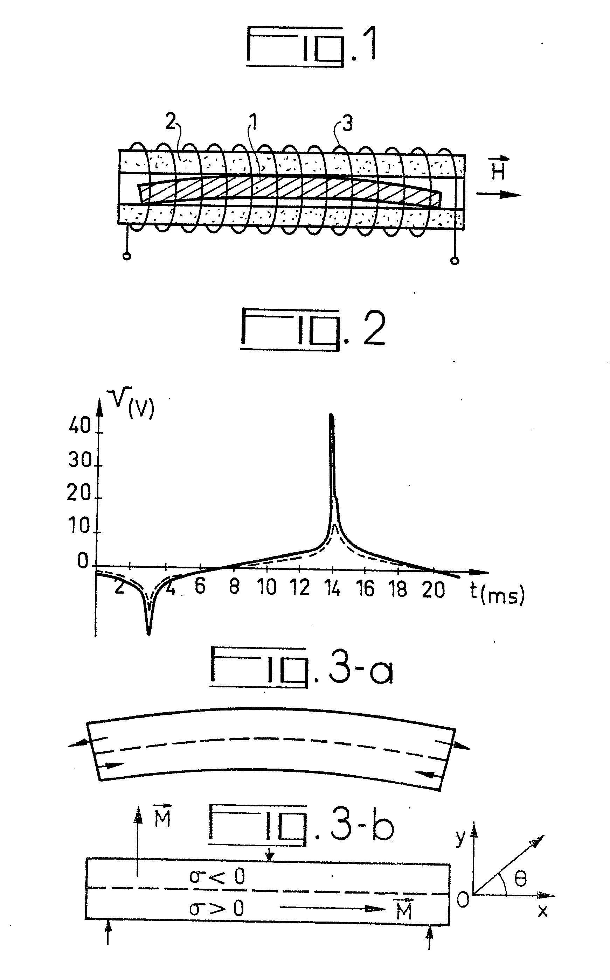

Le capteur magnétique suivant l'invention représenté sur la figure 1 comporte un fil magnétique 1 à forte teneur en Cobalt. Ce fil peut par exemple être formé d'un alliage de composition 48,3% de Cobalt; 48,6% de Fer; 2,75% de Vanadium; et 0,35% de Manganèse. Ce fil peut avoir un diamètre de 0,5 mm. Ce fil, disponible après fabrication en morceaux linéaires est soumis à un traitement simple qui consiste à l'enrouler sur une bobine de façon à le courber, la déformation obtenue (flexion) étant permanente; un morceau de ce fil est alors coupé et introduit dans un tube rigide 2 formant gaine, formé d'un matériau non magnétique, verre, alumine... A titre d'exemple non limitatif, le fil peut avoir une longueur de 20 mm et être introduit dans un tube dont le diamètre intérieur est égal à 1 mm. Dans ces conditions le fil placé dans le tube est soumis à des contraintes, ses deux extrémités venant en appui sur la face interne du tube du fait de la courbure permanente qui lui a été imposée antérieurement. L'ensemble est placé l'intérieur d'une bobine de fil conducteur 3 et suivant l'axe de cette bobine.

Du fait du traitement subi par le fil, l'expérience montre que dans une zone du fil, un axe d'aimantation facile est crée suivant l'axe longitudinal. L'application d'un champ magnétique $\vec{H}$ parallèlement à cet axe entraîne donc un basculement des domaines d'aimantation dans cette zone qui ne sont pas orientés dans le sens du champ, ce basculement correspondant à une variation du flux magnétique qui induit un signal aux bornes de la bobine de détecton 3. Lorsque le champ magnétique change de sens, l'aimantation rebascule et induit une autre variation de flux. Le signal détecté aux bornes de la bobine de détection est représenté sur la figure 2. Pour les valeurs numériques indiquées ci-dessus et avec une bobine ayant 17400 tours, le signal détecté comporte une impulsion dont la durée est égale à une trentaine de microsecondes, et le temps de montée de l'ordre d'une vingtaine de microsecondes. La forme et l'amplitude de cette impulsion sont pratiquement indépendantes de la vitesse d'application du champ magnétique extérieur ainsi que de son amplitude. Toutefois cette amplitude doit être supérieure à une valeur de seuil nécessaire pour produire le basculement de l'aimantation de l'un à l'autre des deux sens de la direction facile d'aimantation. Sur la même figure, le signal obtenu au moyen d'un dispositif analogue mais comportant un fil non contraint a été représenté en pointillés. Ce signal ne comporte pas l'impulsion étroite et de grande amplitude du signal détecté au moyen du capteur comportant un fil traité et contraint. Les valeurs numériques indiquées sur la figure 2 correspondent à une impédance d'entrée du dispositif de mesure égale à 1 MΩ (impédance d'entrée de l'oscilloscope utilisé). Si l'on utilise un circuit de traitement dont l'impédance d'entrée est de 10 kΩ, l'amplitude des impulsions peut être ramenée à 5V, soit le niveau logique actif des circuits logiques classiques. Par conséquent, le signal obtenu peut être traité directement sans être amplifié au préalable.

Les figures 3a) et 3b) sont des schémas explicatifs utilisés pour rapprocher les phénomènes qui se produisent dans le fil magnétique.

Par le traitement initial du fil magnétique deux zones délimitées par un plan médian orthogonal au rayon de courbure sont crées dans ce fil, l'une dans laquelle la courbure a entrainé un allongement du fil, l'autre dans laquelle la courbure a entrainé une diminution de longueur de fil, ces déformations s'accompagnent par ailleurs de déformations radiales (figure 3a). Lorsque le fil est introduit dans le tube, il tend à se redresser du fait du faible diamètre extérieur du tube par rapport au fil courbe, ce qui lui impose des contraintes positives (tension) dans la zone préalablement comprimée et des contraintes négatives (compression) dans l'autre zone (figure 3b). Il existe également dans le matériau d'autres contraintes (cisaillement). Du fait de la présence de cobalt en grande proportion dans l'alliage et ce corps ayant un coefficent de magnétostriction positif très élevé, l'alliage lui-même a un grand coefficient de magnétostriction, $\lambda$, positif.

L'énergie totale du système est égale à la somme des énergies magnétiques de différents types dans le système, $\Sigma E_m$, et de l'énergie induite par effet magnétostrictif inverse par les contraintes appliquées, $E_\sigma$.

Dans une couche mince, cette énergie $E_\sigma$ varie comme $\sigma . \lambda . \sin^2\theta$, où $\sigma$ est un coefficient représentant les contraintes, $\theta$ est l'angle entre l'axe longitudinal du fil, Ox, et l'aimantation dans les différents domaines. Comme il a été indiqué précédemment le fil peut être divisé, en ce qui concerne les contraintes longitudinales en deux zones, l'une où $\sigma$ est positif, l'autre où $\sigma$ est négatif. Dans la zone de tension, $\sigma>0$, pour que le système tende vers un état d'énergie minimale, $\sin\theta$ doit tendre vers zéro, c'est à dire que l'aimantation M aura tendance à s'orienter suivant l'axe longitudinal Ox du fil, créant ainsi suivant cet axe, dans cette zone, un axe d'aimantation facile. Dans la zone en compression $\sigma<0$, pour que le système tende vers un état d'énergie minimale, $\sin\theta$ doit être maximum, soit

$$\theta = \frac{\pi}{2}$$

c'est à dire que l'axe préférentiel d'aimantation créé dans cette zone suivant Oy est orthogonal à l'axe longitudinal du fil. En conséquence, dans cette zone, l'axe du fil correspond à un axe de difficile aimantation.

Lorsqu'un champ magnétique est appliqué suivant cet axe longitudinal alternativement dans un sens et dans l'autre, l'aimantation bascule alternativement dans un sens et dans l'autre, le passage de l'aimantation d'un sens à l'autre suivant cet axe facile s'effectuant rapidement et induisant donc une variation rapide du flux et un signal induit important dans la bobine de détection.

En plus des impulsions de grande amplitude dues à ce basculement rapide de l'aimantation dans la zone où l'axe facile créé est parallèle au fil, des signaux parasites sont également créés. L'un varie lentement et correspond à des variations induites directement dans la bobine de détection; l'autre est induit par la zone du fil en compression. En effet, bien que, pour cette zone, l'axe du fil soit un axe de difficile aimantation, lorsqu'un champ magnétique est appliqué suivant l'axe du fil, un certain nombre de domaines magnétiques s'alignent suivant cet axe et ce basculement crée une variation de flux et donc un signal détecté, mais son amplitude est très inférieure et son temps de montée très supérieur à ceux de l'impulsion crée par basculement des domaines dans l'autre zone du fil.

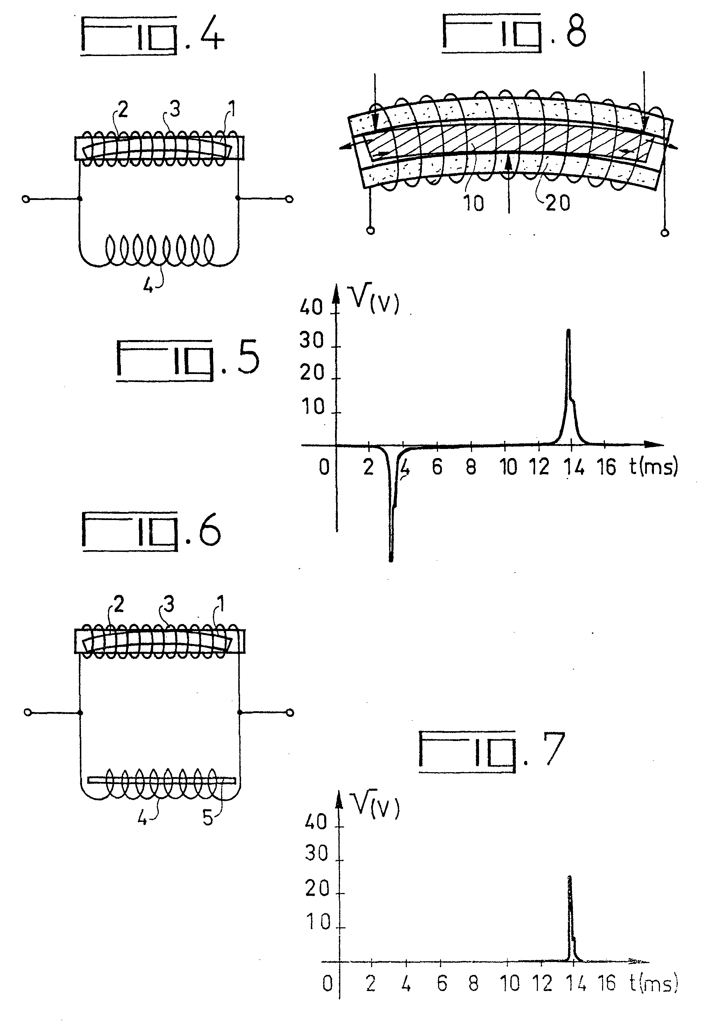

Ces deux signaux parasites peuvent être compensés, au moins partiellement. C'est l'objet des perfectionnements décrits en référence aux figures 4 et 6, les signaux détectés correspondants étant représentés sur les figures 5 et 7.

Le signal parasite induit directement dans la bobine de détection, qui correspond aux variations lentes du signal représenté sur la figure 2 peut être compensé au moyen d'une seconde bobine branchée aux bornes de la première et enroulée en sens contraire, un champ magnétique extérieur induisant dans ces deux bobines des variations de flux en sens contraire qui donnent des signaux détectés de signes contraires qui se compensent. La figure 4 représente ce capteur magnétique comportant une seconde bobine 4. Le signal détecté correspondant représenté sur la figure 5 ne comporte plus que les impulsions correspondant aux basculements d'aimantation.

Le signal parasite induit par la partie du fil en compression peut être compensé partiellement en ajoutant un fil non contraint 5 formant noyau dans la bobine de compensation 5 préalablement décrite. La structure qui en résulte est représentée sur la figure 6 et le signal détecté correspondant est représenté sur la figure 7.

En fait, dans le capteur décrit ci-dessus, un état de contrainte subsiste dans le fil en même temps que la déformation permanente due à la courbure sur la bobine. Lorsqu'un tel fil est introduit dans une gaine droite rigide, les extrémités du fil et son centre viennent en appui sur la face interne de la gaine et les contraintes ainsi appliquées se superposent à celles qui subsistent dans le fil.

Il est donc possible pour améliorer encore les performances, d'effectuer un recuit de stabilisation du matériau, ce recuit permettant de supprimer les contraintes crées par la déformation initiale. Les seules contraintes dans le fil sont alors dues aux appuis de ce fil sur la paroi interne de la gaine.

Un autre mode de réalisation du capteur suivant l'invention est représenté sur la figure 8. Il comporte un fil magnétique 10, non déformé initialement, placé dans une gaine rigide courbe 20. Du fait de la courbure de la gaine, le fil qui y est introduit fléchit en s'appuyant sur la face interne de la gaine (les points d'appui sont comme sur la figure 3b) représentés par des flèches). Cette flexion se traduit par des contraintes longitudinales, tension dans une zone et compression de l'autre, du même type que celles obtenues au moyen d'un fil fléchi introduit dans une gaine droite, qui produisent des effets analogues. En particulier, un axe d'aimantation facile est crée suivant l'axe du fil dans la zone en tension.

Le fil 10 et sa gaine 20 sont placés comme précédemment dans une bobine de détection 3, et le dispositif fonctionne de la même façon. Il est d'ailleurs possible de lui adjoindre une bobine de compensation 4, éventuellement munie d'un noyau formé par un fil non contraint, de façon à éviter les signaux parasites, comme décrit ci-dessus. D'une manière plus générale, le capteur magnétique suivant l'invention comporte donc un fil magnétique soumis à des contraintes longitudinales créées dans ce fil par flexion, un axe d'aimantation facile étant ainsi créé dans la zone du fil en tension suivant l'axe longitudinal du fil, l'aimantation étant susceptible de basculer rapidement d'un sens à l'autre de cet axe facile sous l'action d'un champ magnétique extérieur.

Le capteur ainsi réalisé, qui comporte un fil magnétique ayant subi un traitement mécanique assez simple, présente de bonnes performances et est utilisable dans un grand nombre d'applications, par exemple pour un capteur de position d'éléments mobiles, en translation ou en rotation, pourvu que ce déplacement se traduise par une variation de champ magnétique. Un tel capteur peut également être utilisé comme générateur d'impulsions, associé à un élément créant une variation de champ magnétique. Un tel générateur d'impulsions peut alors être connecté directement à des circuits logiques d'utilisation du fait que l'amplitude des impulsions de sortie, avec une impédance de charge adaptée peut être 5V. De plus, les variations d'amplitude de ces impulsions ne dépassent pas 10 à 15% suivant le fil utilisé quelle que soit la valeur du champ magnétique appliqué pourvu que cette valeur soit supérieure à la valeur de seuil nécessaire au basculement de l'aimantation. Ces fluctuations peuvent d'ailleurs être diminuées lorsque le champ magnétique appliqué au fil a une amplitude constante pendant les instants où il est appliqué.

L'invention n'est pas limitée aux modes de réalisation du capteur précédemment décrits. En particulier la composition du fil magnétique donnée à titre d'exemple n'est nullement limitative et tout autre fil ferromagnétique ayant un coefficient de magnétostriction élevé fléchi de façon à y créer des contraintes longitudinales, permet de fournir des impulsions créées aux bornes de la bobine par variation de flux et dues au basculement de l'aimantation lors de l'application d'un champ magnétique. Cependant, pour obtenir des impulsions de grande amplitude, il est intéressant d'utiliser un fil ferromagnétique à forte teneur en cobalt du fait du grand coefficient de magnétostriction de ce composant.

**Revendications**

1, Capteur magnétique utilisant un matériau magnétique soumis à contrainte, caractérisé en ce qu'il comporte un fil magnétique (1, 10) introduit dans une gaine rigide (2, 20) de matériau non magnétique, les formes respectives du fil et de la gaine étant telles que le fil dans sa gaine est maintenu en flexion créant ainsi des contraintes longitudinales de façon à créer dans une zone du fil une direction facile d'aimantation suivant l'axe longitudinal du fil, l'ensemble fil magnétique et gaine étant placé selon l'axe d'une bobine de détection (3) destinée à fournir des impulsions lors de l'application momentanée d'un champ magnétique au capteur lorsque ce champ induit un basculement de l'aimantation dans le fil magnétique d'un sens à l'autre suivant la direction facile d'aimantation.

2. Capteur magnétique selon la revendication 1, caractérisé en ce que le fil magnétique (1, 10) est constitué d'un alliage ferromagnétique à grande teneur en Cobalt.

3. Capteur magnétique selon la revendication 1, caractérisé en ce que le fil magnétique (1) est traité mécaniquement en flexion jusqu'à présenter une déformation permanente, la gaine dans laquelle ce fil est introduit étant une gaine droite (2).

4. Capteur magnétique selon la revendication 3, caractérisé en ce que le fil magnétique (1) est recuit avant introduction dans la gaine (2) pour supprimer les contraintes subsistant dans le fil avec la déformation permanente.

5. Capteur magnétique selon la revendication 1, caractérisé en ce que la gaine est une gaine courbe (20), le fil magnétique (10) étant droit avant introduction dans sa gaine.

6. Capteur magnétique selon l'une quel-conque des revendications précédentes, carac-térisé en ce qu'une seconde bobine (4) est montée en opposition aux bornes de la première pour compenser la composant de signal détecté induite par le première bobine elle-même lors de l'application d'un champ magnétique à détecter.

7. Capteur magnétique selon la revendication 3, caractérisé en ce qu'un second fil (5) de même nature que le premier mais non contraint est placé suivant l'axe de la seconde bobine (4) pour compenser partiellement la composante de signal détecté induite par la partie de fil contraint dans laquelle les contraintes longitudinales créent un axe d'aimantation facile orthogonal à l'axe longitudinal du fil.

8. Dispositif de détection de proximité d'objets induisant des variations de champ magnétique, caractérisé en ce qu'il comporte un capteur magnétique selon l'une quelconque des revendications précédentes.

**Claims**

1. Magnetic probe using a magnetic material which is submitted to a prestress, characterized by the fact that it comprises a magnetic wire (1, 10) which is inserted into a rigid case (2, 20) of non-magnetic material, the respective shapes of the wire and the case being such that the wire is maintained in bended state which causes longitudinal stresses such that a direction of easy magnetisation along the longitudinal axis of the wire is produced in a zone of the wire, the unit constituted by the magnetic wire and its case being placed along the axis of a detection coil (3) provided to furnish pulses when a magnetic field is momentarily applied to the probe and this field causes the magnetisation in the wire to tip over from one easy magnetisation direction to the other.

2. Magnetic probe according to claim 1, characterized by the fact that the magnetic wire (1, 10) is constituted by a ferromagnetic alloy with a large content of cobalt.

3. Magnetic probe according to claim 1, characterized by the fact that the magnetic wire (1) is mechanically treated by flexion until it presents a permanent deformation, the case in which the wire is inserted being a straight case (2).

4. Magnetic probe according to claim 3, characterized by the fact that the magnetic wire (1) is submitted to a heat treatment before being inserted into the case (2) in view of the suppression of stresses remaining in the wire with its permanent deformation.

5. Magnetic probe according to claim 1, characterized by the fact that the case (20) is curve shaped, the magnetic wire (10) being a straight wire before being inserted into the case.

6. Magnetic probe according to anyone of the preceding claims, characterized by the fact that a second coil (4) is mounted in opposite direction at the terminals of the first coil for compensating the portion of the detected signal which is induced by the first coil itself during application of a magnetic field which is to be detected.

7. Magnetic probe according to claim 3, characterized by the fact that a second wire (5) of the same structure as the first one but without stress is placed along the axis of the second coil (4) for partially compensating the portion of the detected signal which is induced by the zone of the prestressed wire in which the longitudinal stresses create an axis of easy magnetisation perpendicularly to the longitudinal axis of the wire.

8. Device for detecting the proximity of objects which induce variations of the magnetic field, characterized by the fact that it comprises a magnetic probe according to anyone of the preceding claims.

## Patentansprüche

1. Magnetische Sonde, die ein magnetisches, einer mechanischen Spannung unterliegendes Material benutzt, dadurch gekennzeichnet sie einen magnetischen Draht (1, 10) enthält, der in einer starren Hülle (2, 20) aus unmagnetischem Material steckt, wobei die jeweiligen Formen des Drahts und der Hülle so gewählt sind, daß der Draht in seiner Hülle gebogen gehalten wird, wodurch Längsspannungen entstehen, so daß in einer Zone des Drahts eine Richtung leichter Magnetisierbarkeit entlang der Draht-Längsachse gebildet wird, daß weiter die aus dem magnetischen Draht und der Hülle gebildete Einheit entlang der Achse einer Detektorspule (3) angeordnet ist, die Impulse bei plötzlicher Anwendung eines Magnetfeldes auf die Sonde liefert, wenn dieses Magnetfeld zu einem Umkippen der Magentisierung im Magnetdraht von einer zur anderen Richtung leichter Magnetisierbarkeit führt.

2. Magnetische Sonde nach Anspruch 1, dadurch gekennzeichnet, daß der Magnetdraht (1, 10) aus einer ferromagnetischen Legierung mit hohem Kobaltanteil besteht.

3. Magnetische Sonde nach Anspruch 1, dadurch gekennzeichnet, daß der magnetische Draht (1) mechanisch auf Biegung behandelt wird, bis er eine bleibende Verformung aufweist, während die Hülle (2), in der der Draht steckt, geradlinig ist.

4. Magnetische Sonde nach Anspruch 3, dadurch gekennzeichnet, daß der magnetische Draht (1) vor dem Einführen in die Hülle (2) einer Wärmebehandlung unterzogen wird, um Restspannungen in dem bleibend verformten Draht zu beseitigen.

5. Magnetische Sonde nach Anspruch 1, dadurch gekennzeichnet, daß die Hülle (20) kurvenförmig ausgebildet ist, während der magnetische Draht (10) vor seiner Einführung in die Hülle geradlinig ist.

6. Magnetische Sonde nach einem der vorhergehenden Ansprüche, dadurch gekennzeichnet, daß eine zweite Spule (4) gegensinnig an die Anschlüsse der ersten Spule angeschlossen ist, um die durch die erste Spule selbst während der Anwendung eines zu entdeckenden Magnetfeldes induzierte Komponente des erkannten Signals zu kompensieren.

7. Magnetische Sonde nach Anspruch 3, dadurch gekennzeichnet, daß ein zweiter, dem ersten gleicher aber nicht vorgespannter Draht (5) entlang der Achse der zweiten Spule (4) angeordnet ist, um die durch den Bereich des vorgespannten Drahts, in dem die Längsspannungen eine Achse leichter Magnetisierbarkeit senkrecht zur Längsachse des Drahtes erzeugen, induzierte Komponente des erkannten Signals teilweise zu kompensieren.

8. Vorrichtung zum Ermitteln der Annäherung von Gegenständen, die Magnetfeld-Änderungen induzieren, dadurch gekennzeichnet, daß sie eine magnetische Sonde nach einem der vorhergehenden Ansprüche aufweist.

FI□.1

FI□. 2

FI□.3-a

FI□.3-b

FIG.4

FIG.8

FIG.5

FIG.6

FIG.7

2